# EUROPEAN PATENT APPLICATION

(11) **EP 1 303 038 A1**
(43) Date of publication of application: **16.04.2003**
(21) Application number: 02022948.0
(22) Date of filing: 11.10.2002
(51) Int. Cl.: H03D 7/16, H04B 15/06

(54) **Input circuit for tuner and semiconductor device**

(30) Priority: 12.10.2001 JP 2001315457
(71) Applicant: Kabushiki Kaisha Toshiba, Tokyo 105-8001 (JP)
(72) Inventor: Ichimura, Kazuya, c/o Int. Property Division, Tokyo (JP)
(74) Representative: HOFFMANN - EITLE

(57) **Abstract**

An input circuit for a tuner having a first input terminal to receive a first radio frequency signal and a second input terminal to receive a second radio frequency signal, the input circuit including a converter and a rear circuit configured to process a first intermediate frequency signal. The converter includes a first local oscillator configured to generate a first local signal serving when converting the first and second radio frequency signals into a first intermediate frequency signal and a first mixer configured to mix the first local signal with the first and second radio frequency signals and to generate the first intermediate frequency signal.

## Description

### CROSS REFERENCE TO RELATED APPLICATIONS

This application is based upon and claims the benefit of priority from the prior Japanese Patent Application P2001-315457 filed on October 12, 2001; the entire contents of which are incorporated herein by reference.

### BACKGROUND OF THE INVENTION

### 1. Field of the Invention

The present invention relates to an input circuit for a tuner and a semiconductor device merging the input circuit. In particular, it relates to an input circuit for a tuner employing a heterodyne detecting technique and the semiconductor device merging the input circuit.

### 2. Description of the Related Art

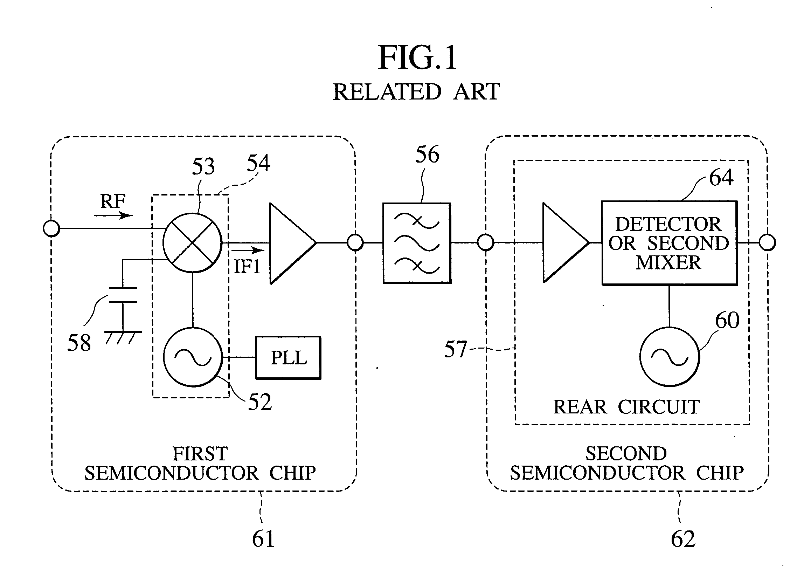

The heterodyne detecting technique is employed by many tuners to improve received channel selectivity. As illustrated in Fig. 1, the input circuit for the tuner includes a converter 54 having a first local oscillator 52 and a first mixer 53. The converter 54 converts a radio frequency signal RF into a first intermediate frequency signal IF1, which is supplied to a rear circuit 57 through a band pass filter 56. The rear circuit 57 has a detector 64 or a second mixer 64. The detector 64 detects the intermediate frequency signal IF1, or the second mixer converts the intermediate frequency signal IF1 into a second intermediate frequency signal. The converter 54 is merged in a first semiconductor chip 61, and the rear circuit 57 is merged in a second semiconductor chip 62. An input style of the radio frequency signal RF is single-terminal style. "Single-terminal style" supplies the radio frequency signal RF to a first input terminal of the first mixer 53, which is made of a Gilbert cell, and grounds a second input terminal of the first mixer 53 via a ground capacitor 58 within the first semiconductor chip 61.

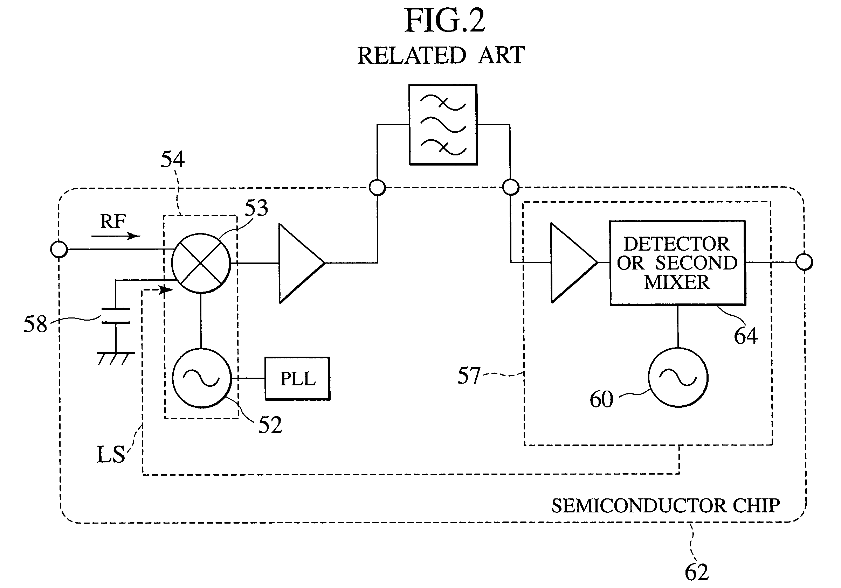

For saving on production costs and a mounting space, as shown in Fig. 2, a converter 54 and a rear circuit 57 are preferably merged in the same semiconductor chip 59. Isolation performance between the converter 54 and the rear circuit 57 in the same semiconductor chip 59 is lower than that between the converter 54 in the first semiconductor 61 and the rear circuit 57 in the separate second semiconductor chip 62. Accordingly, the input circuit for the tuner of Fig. 2 has a signal leakage problem between the converter 54, and the rear circuit 57.

For example, a leaked signal LS consisted by a detected signal or the second intermediate frequency signal and harmonic signals of the second intermediate frequency signal may leak through a semiconductor substrate and the ground capacitor 58 into the second terminal of the first mixer 53. Then, the first mixer 53 converts leaked signals LS into an intermediate frequency signal, causing beat interference with a specific channel.

The case in which the rear circuit 57 includes a second local oscillator 60 is considered. The second local oscillator 60 generates a local signal, which is generally larger than a radio frequency signal RF. As a result, the leaked signal LS easily leak, causing beat interference.

### SUMMARY OF THE INVENTION

A first aspect of the present invention provides an input circuit for a tuner having a first input terminal to receive a first radio frequency signal and a second input terminal to receive a second radio frequency signal, the input circuit including a converter and a rear circuit configured to process a first intermediate frequency signal. The converter includes a first local oscillator configured to generate a first local signal serving when converting the first and second radio frequency signals into the first intermediate frequency signal and a first mixer configured to mix the first local signal with the first and second radio frequency signals and to generate the first intermediate frequency signal.

A second aspect of the present invention provides an input circuit for a tuner having a first input terminal to receive a radio frequency signal and a second input terminal AC-grounded outside a semiconductor chip, the input circuit including a converter and a rear circuit configured to process a first intermediate frequency signal. The converter includes a first local oscillator configured to generate a first local signal serving when converting the radio frequency signal into the first intermediate frequency signal and a first mixer configured to mix the first local signal with the radio frequency signal and to generate the first intermediate frequency signal.

A third aspect of the present invention provides a semiconductor device having a first input terminal to receive a first radio frequency signal and a second input terminal to receive a second radio frequency signal, the semiconductor device including a semiconductor chip, a converter configured to be arranged on the semiconductor chip, and a rear circuit configured to be arranged on the semiconductor chip, to process a first intermediate frequency signal. The converter includes a first local oscillator generating a first local signal serving when converting the first and second radio frequency signals into a first intermediate frequency signal and a first mixer mixing the first local signal with the first and second radio frequency signals and generating the first intermediate frequency signal.

A fourth aspect of the present invention provides a semiconductor device having a first input terminal to receive a radio frequency signal and a second input terminal AC-grounded outside a semiconductor chip including the semiconductor chip, a converter arranged on the semiconductor chip, and a rear circuit arranged on the semiconductor chip, processing a first intermediate frequency signal. The converter includes a first local oscillator generating a first local signal serving when converting the radio frequency signal into the first intermediate frequency signal, and a first mixer mixing the first local signal with the radio frequency signal and generating the first intermediate frequency signal.

### BRIEF DESCRIPTION OF THE DRAWINGS

Figure 1 is a block diagram showing an input circuit for a tuner employing a heterodyne technique according to a related art;
Fig. 2 is a block diagram showing an input circuit for a tuner according to another related art with a converter and a rear circuit merged in the same semiconductor chip;
Fig. 3 is a block diagram showing an input circuit for a tuner according to the embodiment of the present invention;
Fig. 4 is a block diagram showing an input circuit for a tuner according to the first modification of the embodiment with a second input terminal being AC grounded outside semiconductor chip; and
Fig. 5 is a block diagram showing an input circuit for a tuner according to the second modification of the embodiment employing a second mixer instead of a detector.

### DETAILED DESCRIPTION OF EMBODIMENTS

Various embodiments of the present invention will be described with reference to the accompanying drawings. It is to be noted that the same or similar reference numerals are applied to the same or similar parts and elements throughout the drawings, and the description of the same or similar parts and elements will be omitted or simplified.

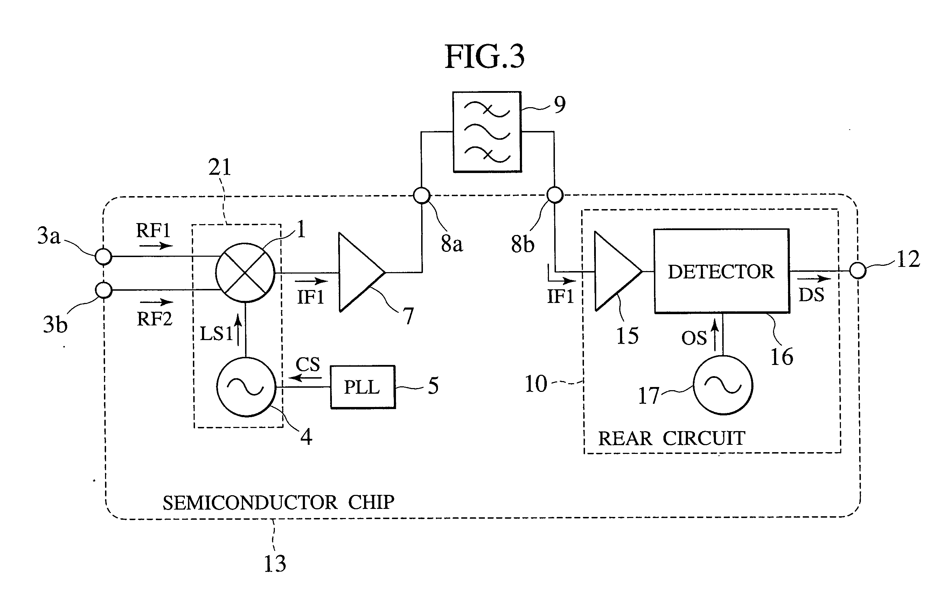

As illustrated in Fig. 3, an input circuit for a tuner according to the embodiment of the present invention includes a semiconductor chip 13, a first input terminal 3a and a second input terminal 3b arranged on the semiconductor chip 13, a converter 21 connected to the first and second input terminals 3a and 3b, a phase locked loop (PLL) circuit 5 connected to the converter 21, an intermediate frequency (IF) amplifier 7 connected to the converter 21, a band pass filter 9 connected to the IF amplifier 7, and a rear circuit 10 connected to the band pass filter 9. The converter 21, PLL circuit 5, IF amplifier 7, and rear circuit 10 are arranged on the semiconductor chip 13. The band pass filter 9 is arranged outside the semiconductor chip 13. The first terminal of the band pass filter 9 is connected to the IF amplifier 7 via an external terminal 8a of the semiconductor chip 13, and the second terminal of the band pass filter 9 is connected to the rear circuit 10 via an external terminal 8b of the semiconductor chip 13.

The converter 21 has a first mixer 1 connected to the first and second input terminals 3a and 3b and a first local oscillator 4 connected to the first mixer 1 and the PLL circuit 5. The first mixer 1 is made of a Gilbert cell and has two inputs connected to the first and second input terminals 3a and 3b, respectively.

The rear circuit 10 includes a preamplifier 15 connected to the band pass filter 9 via the external terminal 8b, a detector 16 connected to the preamplifier 15, and a second local oscillator 17 connected to the detector 16.

The first input terminal 3a receives a first radio frequency signal RF1, and the second input terminal 3b receives a second radio frequency signal RF2. The first local oscillator 4 generates a first local signal LS1 serving when converting the first and second radio frequency signals RF1 and RF2 into a first intermediate frequency signal IF1. The first mixer 1 mixes the first local signal LS1 with the first and second radio frequency signals RF1 and RF2 and generates the first intermediate frequency signal IF1. In other words, the first mixer 1 uses the frequency of the first local signal LS1 to convert the first and second radio frequency signals RF1 and RF2 into the first intermediate frequency signal IF1. Therefore, the converter 21 may convert the first and second radio frequency signals RF1 and RF2 into the first intermediate frequency signal IF1.

The PLL circuit 5 has at least a phase comparator, a low-band pass filter, and a reference oscillator. The phase comparator compares the frequency phase of the first local signal LS1 with that of a reference oscillation signal provided by the reference oscillator and generates a control signal CS. The PLL circuit 5 supplies the control signal CS to the first local oscillator 4 to control the frequency of the first local signal LS1. The PLL circuit 5 has a quartz oscillator as the reference oscillator so that the first local oscillator 4 may correctly and stably generate the first local signal LS1.

The IF amplifier 7 amplifies the first intermediate frequency signal IF1 generated by the first mixer 1. The band pass filter 9 has a fixed pass band. The first intermediate frequency signal IF1 amplified by the IF amplifier 7 is passed through the band pass filter 9 and is transmitted to the rear circuit 10. Namely, frequency components only within the fixed pass band in the first intermediate frequency signal IF1 are transmitted to the rear circuit 10.

The preamplifier 15 amplifies the first intermediate frequency signal IF1 transmitted from the band pass filter 9. The oscillator 17 generates an oscillating signal OS serving when detecting the first intermediate frequency signal IF1. The frequency of the oscillating signal OS is equal to the first intermediate frequency signal IF1. The detector 16 mixes the oscillating signal OS with the first intermediate frequency signal IF1 and provides the detected signal DS. In other words, the detector 16 uses the oscillating signal OS to detect the first intermediate frequency signal IF1. The detected signal DS is provided outside the semiconductor chip 13 via an external terminal 12. Therefore, the rear circuit 10 may detect the first intermediate frequency signal IF1 and provide a detected signal DS.

As explained above, the first and second radio frequency signals RF1 and RF2 are supplied to the first and second input terminals 3a and 3b, respectively. The first and second input terminals 3a and 3b are connected to the inputs of the first mixer 1. The inputs to the first mixer 1 are not AC-grounded within the semiconductor chip 13. Here, "AC-grounded" indicates, "grounded via a ground capacitor". As a result, the detected signal DS, oscillating signal OS, and harmonics of the oscillating signal OS do not leak to the first mixer 1, thereby preventing beat interference.

### (FIRST MODIFICATION)

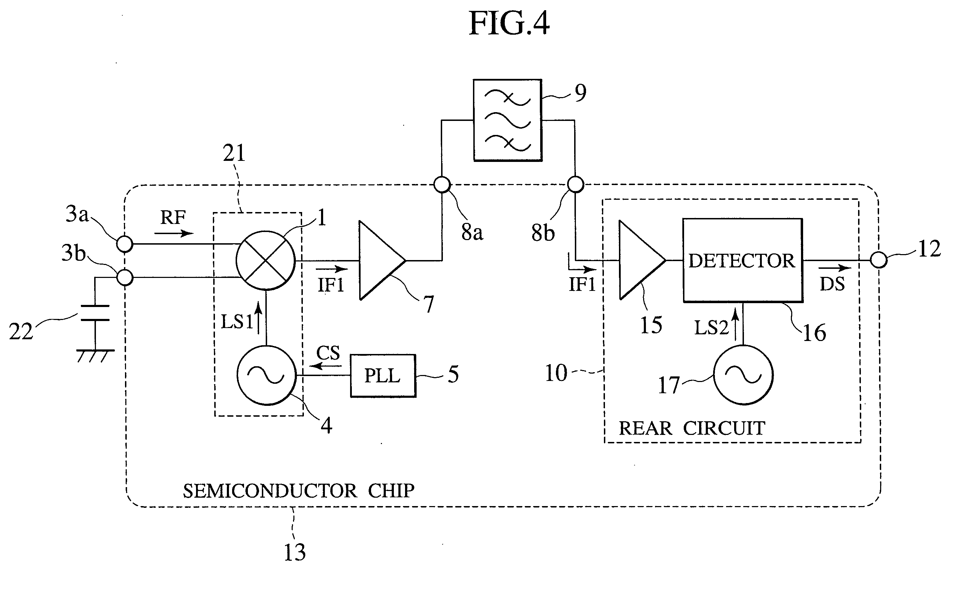

As illustrated in Fig. 4, an input circuit for a tuner according to the first modification of the embodiment of the present invention includes a semiconductor chip 13, a first input terminal 3a and a second input terminal 3b arranged on the semiconductor chip 13, a converter 21 connected to the first and second input terminals 3a and 3b, a PLL circuit 5 connected to the converter 21, an IF amplifier 7 connected to the converter 21, a band pass filter 9 connected to the IF amplifier 7, and a rear circuit 10 connected to the band pass filter 9. The converter 21, PLL circuit 5, IF amplifier 7, and rear circuit 10 are arranged on the semiconductor chip 13. The band pass filter 9 is arranged outside the semiconductor chip 13. The first terminal of the band pass filter 9 is connected to the IF amplifier 7 via an external terminal 8a of the semiconductor chip 13, and the second terminal of the band pass filter 9 is connected to the rear circuit 10 via an external terminal 8b of the semiconductor chip 13. The second input terminal 3b is grounded via a ground capacitor 22 outside the semiconductor chip 13. In other words, the second input terminal 3b is AC-grounded outside the semiconductor chip 13.

The converter 21 has a first mixer 1 connected to the first and second input terminals 3a and 3b and a first local oscillator 4 connected to the first mixer 1 and the PLL circuit 5. The first mixer 1 is made of a Gilbert cell and has two inputs connected to the first and second input terminals 3a and 3b, respectively.

The rear circuit 10 includes a preamplifier 15 connected to the band pass filter 9 via the external terminal 8b, a detector 16 connected to the preamplifier 15, and an oscillator 17 connected to the detector 16.

The first input terminal 3a receives a radio frequency signal RF. The first local oscillator 4 generates a first local signal LS1 serving when converting the radio frequency signal RF into a first intermediate frequency signal IF1. The frequency of the first local signal LS1 is determined by the frequency of the radio frequency signal RF and the frequency of the first intermediate frequency signal IF1 and is dependent on the receiving frequency band of the tuner. The first mixer 1 mixes the first local signal LS1 with the radio frequency signals RF and generates the first intermediate frequency signal IF1. Therefore, the converter 21 may convert the radio frequency signals RF into the first intermediate frequency signal IF1.

The PLL circuit 5 has at least a phase comparator, a low-band pass filter, and a reference oscillator. The phase comparator compares the frequency phase of the first local signal LS1 with that of a reference oscillation signal provided by the reference oscillator and generates a control signal CS. The PLL circuit 5 supplies the control signal CS to the first local oscillator 4 to control the frequency of the first local signal LS1. The PLL circuit 5 has a quartz oscillator as the reference oscillator so that the first local oscillator 4 may correctly and stably generate the first local signal LS1.

The IF amplifier 7 amplifies the first intermediate frequency signal IF1 generated by the first mixer 1. The first intermediate frequency signal IF1 amplified by the IF amplifier 7 is passed through the band pass filter 9 and is transmitted to the rear circuit 10.

The preamplifier 15 amplifies the first intermediate frequency signal IF1 transmitted from the band pass filter 9. The oscillator 17 generates an oscillating signal OS serving when detecting the first intermediate frequency signal IF1. The detector 16 mixes the oscillating signal OS with the first intermediate frequency signal IF1 and provides the detected signal DS. The detected signal DS is provided outside the semiconductor chip 13 via an external terminal 12. Therefore, the rear circuit 10 may detect the first intermediate frequency signal IF1 and provide a detected signal DS.

As explained above, the radio frequency signal RF is supplied to the first input terminal 3a. The second input terminal 3b is AC-grounded outside the semiconductor chip 13. As a result, the detected signal DS, oscillating signal OS, and harmonics of the oscillating signal OS do not leak to the first mixer 1, thereby preventing beat interference.

### (SECOND MODIFICATION)

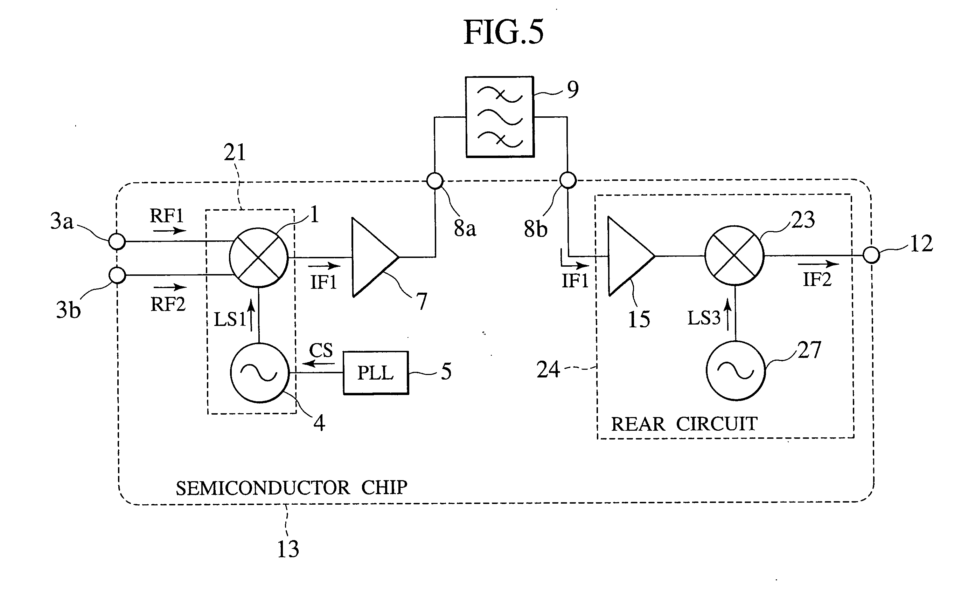

As illustrated in Fig. 5, an input circuit for a tuner according to the second modification of the embodiment of the present invention includes a semiconductor chip 13, a first input terminal 3a and a second input terminal 3b arranged on the semiconductor chip 13, a converter 21 connected to the first and second input terminals 3a and 3b, a PLL circuit 5 connected to the converter 21, an IF amplifier 7 connected to the converter 21, a band pass filter 9 connected to the IF amplifier 7, and a rear circuit 24 connected to the band pass filter 9. The converter 21, PLL circuit 5, IF amplifier 7, and rear circuit 24 are arranged on the semiconductor chip 13. The band pass filter 9 is arranged outside the semiconductor chip 13. The first terminal of the band pass filter 9 is connected to the IF amplifier 7 via an external terminal 8a of the semiconductor chip 13, and the second terminal of the band pass filter 9 is connected to the rear circuit 24 via an external terminal 8b of the semiconductor chip 13.

The converter 21 has a first mixer 1 connected to the first and second input terminals 3a and 3b and a first local oscillator 4 connected to the first mixer 1 and the PLL circuit 5. The first mixer 1 is made of a Gilbert cell and has two inputs connected to the first and second input terminals 3a and 3b, respectively.

The rear circuit 24 includes a preamplifier 15 connected to the band pass filter 9 via the external terminal 8b, a second mixer 23 connected to the preamplifier 15, and a second local oscillator 27 connected to the second mixer 23.

The first input terminal 3a receives a first radio frequency signal RF1, and the second input terminal 3b receives a second radio frequency signal RF2. The first local oscillator 4 generates a first local signal LS1 serving when converting the first and second radio frequency signals RF1 and RF2 into a first intermediate frequency signal IF1. The frequency of the first local signal LS1 is determined by the frequencies of the first and second radio frequency signals RF1 and RF2 and the frequency of the first intermediate frequency signal IF1 and is dependent on the receiving frequency band of the tuner. The first mixer 1 mixes the first local signal LS1 with the first and second radio frequency signals RF1 and RF2 and generates the first intermediate frequency signal IF1. Therefore, the converter 21 may convert the first and second radio frequency signals RF1 and RF2 into the first intermediate frequency signal IF1.

The PLL circuit 5 has at least a phase comparator, a low-band pass filter, and a reference oscillator. The phase comparator compares the frequency phase of the first local signal LS1 with that of a reference oscillation signal provided by the reference oscillator and generates a control signal CS. The PLL circuit 5 supplies the control signal CS to the first local oscillator 4 to control the frequency of the first local signal LS1.

The IF amplifier 7 amplifies the first intermediate frequency signal IF1 generated by the first mixer 1. The first intermediate frequency signal IF1 amplified by the IF amplifier 7 is passed through the band pass filter 9 and is transmitted to the rear circuit 24.

The preamplifier 15 amplifies the first intermediate frequency signal IF1 transmitted from the band pass filter 9. The second local oscillator 27 generates a second local signal LS3 serving when converting the first intermediate frequency signal IF1 into a second intermediate frequency signal IF2. The frequency of the second local signal LS3 is determined by the frequency of the first intermediate frequency signal IF1 and the second intermediate frequency signal IF2. The second mixer 23 mixes the second local signal LS3 with the first intermediate frequency signal IF1 and provides the second intermediate frequency signal IF2. The second intermediate frequency signal IF2 is provided outside the semiconductor chip 13 via an external terminal 12. Therefore, the rear circuit 24 may convert the first intermediate frequency signal IF1 into the second intermediate frequency signal IF2.

As explained above, the first and second radio frequency signals RF1 and RF2 are supplied to the first and second input terminals 3a and 3b, respectively. The first and second input terminals 3a and 3b are connected to the inputs of the first mixer 1. As a result, the second intermediate frequency signal IF2, second local signal LS3, and harmonics of the second local signal LS3 do not leak to the first mixer 1, thereby preventing beat interference.

The input circuits for a tuner as shown in Figs. 3 to 5 may be realized as a tuner input device for a tuner or semiconductor device having the semiconductor chip 13, first and second input terminals 3a and 3b, converter 21, and rear circuit 10 or 24, respectively.

In the input circuits for a tuner as shown in Figs. 3 to 5, the band pass filter 9 is arranged outside the semiconductor chip 13. Instead, the band pass filter 9 may be arranged on the semiconductor chip 13.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

## Claims

1. An input circuit for a tuner having a first input terminal to receive a first radio frequency signal and a second input terminal to receive a second radio frequency signal, the input circuit comprising:
a converter comprising:
a first local oscillator configured to generate a first local signal serving when converting the first and second radio frequency signals into a first intermediate frequency signal; and
a first mixer configured to mix the first local signal with the first and second radio frequency signals and to generate the first intermediate frequency signal; and
a rear circuit configured to process the first intermediate frequency signal.

2. The input circuit of claim 1, wherein said rear circuit comprises:
an oscillator configured to generate an oscillating signal serving when detecting the first intermediate frequency signal; and
a detector configured to mix the oscillating signal with the first intermediate frequency signal and to detect the first intermediate frequency signal.

3. The input circuit of claim 1, wherein said rear circuit comprises:
a second local oscillator configured to generate a second local signal nerving when converting the first intermediate frequency signal into a second intermediate frequency signal; and
a second mixer configured to mix the second local signal with the first intermediate frequency signal and to generate the second intermediate frequency signal.

4. The input circuit of claim 1, further comprising a phase locked loop circuit configured to control a frequency of the first local signal.

5. The input circuit of claim 1, further comprising a band pass filter configured to pass a fixed frequency band.

6. An input circuit for a tuner having a first input terminal to receive a radio frequency signal and a second input terminal AC-grounded outside a semiconductor chip, the input circuit comprising:
a converter comprising:
a first local oscillator configured to generate a first local signal serving when converting the radio frequency signal into a first intermediate frequency signal; and
a first mixer configured to mix the first local signal with the radio frequency signal and to generate the first intermediate frequency signal; and
a rear circuit configured to process the first intermediate frequency signal.

7. The input circuit of claim 6, wherein said rear circuit comprises:
an oscillator configured to generate an oscillating signal serving when detecting the first intermediate frequency signal; and
a detector configured to mix the oscillating signal with the first intermediate frequency signal and to detect the first intermediate frequency signal.

8. The input circuit of claim 6, wherein said rear circuit comprises:
a second local oscillator configured to generate a second local signal serving when converting the first intermediate frequency signal into a second intermediate frequency signal; and
a second mixer configured to mix the second local signal with the first intermediate frequency signal and to generate the second intermediate frequency signal.

9. The input circuit of claim 6, further comprising a phase locked loop circuit configured to control a frequency of the first local signal.

10. The input circuit of claim 6, further comprising a band pass filter configured to pass a fixed frequency band.

11. A semiconductor device having a first input terminal to receive a first radio frequency signal and a second input terminal to receive a second radio frequency signal, the semiconductor device comprising:
a semiconductor chip;
a converter configured to be arranged on said semiconductor chip, comprising:
a first local oscillator configured to generate a first local signal serving when converting the first and second radio frequency signals into a first intermediate frequency signal; and
a first mixer configured to mix the first local signal with the first and second radio frequency signals and to generate the first intermediate frequency signal; and
a rear circuit configured to be arranged on said semiconductor chip, to process the first intermediate frequency signal.

12. The semiconductor device of claim 11, wherein said rear circuit comprises:
an oscillator configured to generate a oscillating signal serving when detecting the first intermediate frequency signal; and
a detector configured to mix the oscillating signal with the first intermediate frequency signal and to detect the first intermediate frequency signal.

13. The semiconductor device of claim 11, wherein said rear circuit comprises:
a second local oscillator configured to generate a second local signal serving when converting the first intermediate frequency signal into a second intermediate frequency signal; and
a second mixer configured to mix the second local signal with the first intermediate frequency signal and to generate the second intermediate frequency signal.

14. The semiconductor device of claim 11, further comprising a phase locked loop circuit configured to control a frequency of the first local signal.

15. The semiconductor device of claim 11, further comprising a band pass filter configured to pass a fixed frequency band.

16. A semiconductor device having a first input terminal to receive a radio frequency signal and a second input terminal AC-grounded outside a semiconductor chip comprising:
said semiconductor chip;
a converter configured to be arranged on said semiconductor chip, comprising:
a first local oscillator configured to generate a first local signal serving when converting the radio frequency signal into a first intermediate frequency signal; and
a first mixer configured to mix the first local signal with the radio frequency signal and to generate the first intermediate frequency signal; and
a rear circuit configured to be arranged on said semiconductor chip, to process the first intermediate frequency signal.

17. The semiconductor device of claim 16, wherein said rear circuit comprises:
an oscillator configured to generate an oscillating signal serving when detecting the first intermediate frequency signal; and
a detector configured to mix the oscillating signal with the first intermediate frequency signal and to detect the first intermediate frequency signal.

18. The semiconductor device of claim 16, wherein said rear circuit comprises:
a second local oscillator configured to generate a second local signal serving when converting the first intermediate frequency signal into a second intermediate frequency signal; and
a second mixer configured to mix the second local signal with the first intermediate frequency signal and to generate the second intermediate frequency signal.

19. The semiconductor device of claim 16, further comprising a phase locked loop circuit configured to control a frequency of the first local signal.

20. The semiconductor device of claim 16, further comprising a band pass filter configured to pass a fixed frequency band.
